# FASCICULE DE BREVET EUROPEEN

(11) **EP 3 350 842 B1**
(45) Date de publication et mention de la délivrance du brevet: **18.03.2020**
(21) Numéro de dépôt: 16774542.1
(22) Date de dépôt: 15.09.2016
(51) Int. Cl.: H01L 31/0352, H01L 31/101

(54) **PHOTODÉTECTEUR À COURANT D'OBSCURITÉ RÉDUIT**
PHOTODETEKTOR MIT REDUZIERTEM DUNKELSTROM
PHOTODETECTOR WITH REDUCED DARK CURRENT

(30) Priorité: 16.09.2015 FR 1558673
(43) Date de publication de la demande: 25.07.2018
(73) Titulaire: LYNRED, 91120 Palaiseau (FR)
(72) Inventeur: RUBALDO, Laurent, 38600 Fontaine (FR); PERE LAPERNE, Nicolas, 38000 Grenoble (FR); KERLAIN, Alexandre, 38000 Grenoble (FR); NEDELCU, Alexandru, 92340 Bourg la Reine (FR)
(74) Mandataire: Talbot, Alexandre
(86) Numéro de dépôt international: PCT/FR2016/052332
(87) Numéro de publication internationale: WO 2017/046529

(56) Documents cités:
- EP-A2- 2 802 018
- JP-A- 2012 207 968
- US-A1- 2012 145 996
- MARTYNIUK P ET AL: "Barrier infrared detectors", OPTO-ELECTRONICS REVIEW, WARSZAWA, PL, vol. 22, no. 2, 21 mars 2014 (2014-03-21), pages 127-146, XP035349551, ISSN: 1230-3402, DOI: 10.2478/S11772-014-0187-X [extrait le 2014-03-21]
- TING DAVID Z ET AL: "Type II superlattice barrier infrared detector", INFRARED REMOTE SENSING AND INSTRUMENTATION XIX, SPIE, 1000 20TH ST. BELLINGHAM WA 98225-6705 USA, vol. 8154, no. 1, 8 septembre 2011 (2011-09-08), pages 1-12, XP060017804, DOI: 10.1117/12.896240

## Description

### Domaine de l'invention

L'invention est relative à un photodétecteur comportant une zone absorbante séparée d'une zone de contact par une zone de blocage des porteurs majoritaires photogénérés.

### Etat de la technique

Dans de nombreuses activités, une scène est observée par un dispositif de détection qui comporte un photodétecteur. Le photodétecteur reçoit un signal lumineux qu'il transforme en un signal électrique représentatif de la scène observée.

De manière conventionnelle, le photodétecteur est une photodiode qui comporte une jonction p-n, c'est-à-dire qu'elle possède une zone semiconductrice dopée de type n mise en contact avec une zone semiconductrice de type p.

La mise en contact de ces deux zones semiconductrices entraine une courbure des bandes de valence et de conduction ainsi que la création d'une zone de déplétion au niveau de la jonction métallurgique.

Lorsqu'un photon est absorbé, un électron et un trou d'électron sont générés dans les bandes de conduction et de valence.

Si une polarisation nulle ou inverse est appliquée aux bornes de la photodiode, les porteurs de charges photogénérés sont collectés et il est alors possible de corréler au moins en partie l'intensité du courant mesuré avec le flux de lumière reçu.

Pour observer un flux de lumière de faible intensité, il est particulièrement important d'utiliser des photodiodes qui présentent des niveaux de bruit qui sont très faibles et minimisant notamment les courants parasites.

Une architecture alternative est présentée dans le document US 2007/0215900 qui présente un photodétecteur muni d'une zone absorbante dopée de type n et séparée d'une zone de contact semiconductrice par une zone de blocage qui présente un niveau de bande de conduction très supérieur au niveau de la bande de conduction de la zone absorbante de manière à empêcher le passage des porteurs de charges majoritaires.

De manière classique, dans une photodiode, le courant parasite est également appelé courant d'obscurité car il est mesuré quand la photodiode n'est soumise à aucune stimulation lumineuse extérieure.

Le courant d'obscurité possède au moins deux composantes qui sont un courant de diffusion et un courant de « Génération-Recombinaison ». Le courant de diffusion correspond à l'excitation thermique des porteurs de charge électrique qui peuvent alors se déplacer entre les bandes de valence et de conduction. Une manière efficace de réduire cette composante de bruit est de refroidir la photodiode.

La diminution de la température de fonctionnement permet également de réduire la deuxième composante de bruit mais de manière nettement moins efficace. La deuxième composante de bruit correspond à la génération et à la recombinaison des porteurs de charges à partir de niveaux d'énergie situés en général au milieu de la bande interdite.

Pour réduire cette deuxième composante de bruit, à savoir le bruit de « Génération-Recombinaison », différents enseignements sont disponibles.

Le document US 2009/0256231 décrit l'utilisation d'un dispositif d'un seul type de dopage où deux couches de type n à bandgap étroit entourent une troisième couche à bandgap plus important en matériau barrière.

Ce document décrit également un dispositif à deux types de dopages différents n et p dans lequel la région absorbante comporte une zone sans déplétion.

Le document EP2802018 divulgue une diode pour la détection de l'infrarouge présentant une zone barrière constituée d'un super-réseau.

### Objet de l'invention

L'invention a pour objet un photodétecteur qui permet une diminution du courant parasite et de la consommation électrique du système optronique.

On tend à atteindre ce résultat au moyen d'un photodétecteur tel que défini dans la revendication 1.

Dans un mode de réalisation particulier, la zone de blocage comporte un quatrième matériau semi-conducteur présentant une quatrième valeur d'énergie de bande interdite supérieure à la première valeur d'énergie de bande interdite et différente de la deuxième valeur d'énergie de bande interdite et de la troisième valeur d'énergie de bande interdite.

Il est également possible de prévoir que le photodétecteur comporte un substrat comprenant la zone absorbante, la zone de blocage, la zone de contact et une zone de support et en ce que la zone de support est séparée de la zone de contact par la zone absorbante et la zone de blocage.

Dans un cas particulier, le photodétecteur comporte :
- une zone de contact additionnelle et
- une zone de blocage additionnelle disposée entre la zone absorbante et la zone de contact additionnelle, la zone de blocage additionnelle étant configurée pour bloquer les porteurs de charge minoritaires entre la zone absorbante et la zone de contact additionnelle.

Dans une variante de réalisation, la zone de contact additionnelle est disposée entre la zone de support et la zone absorbante.

Il est encore possible de prévoir que la zone de blocage additionnelle comporte au moins un puits quantique réalisée en cinquième et sixième matériaux semi-conducteurs présentant respectivement des cinquième et sixième valeurs d'énergie de bande interdite, la cinquième et/ou la sixième valeur d'énergie de bande interdite étant supérieure à la première valeur d'énergie de bande interdite.

Dans un mode de réalisation particulier, le premier matériau semi-conducteur est le troisième matériau semi-conducteur et/ou le cinquième matériau semi-conducteur.

De manière préférentielle, la zone de blocage et/ou la zone de blocage additionnelle sont dopées sur toute leur épaisseur.

Dans un mode de réalisation particulier, la zone de blocage définit une ou plusieurs zones de puits de potentiel et plusieurs zones de barrière de potentiel et en ce que la zone de blocage est dopée uniquement dans une ou plusieurs desdites zones de puits de potentiel.

Dans une variante de réalisation, la zone de blocage définit une ou plusieurs zones de puits de potentiel et plusieurs zones de barrière de potentiel et en ce que la zone de blocage est dopée uniquement hors de la ou des zones de puits de potentiel.

Il est avantageux de prévoir que la zone de blocage comporte une alternance de couches en deuxième matériau semi-conducteur et en troisième matériau semi-conducteur et en ce que les couches en deuxième matériau semi-conducteur sont contraintes en tension et les couches en troisième matériau semi-conducteur sont contraintes en compression.

Plus particulièrement, la zone de blocage peut comporter entre 1 et 10 puits quantiques.

De manière avantageuse, la zone de blocage est en contact direct avec la zone absorbante. De manière préférentielle, la zone de blocage est en contact direct avec la zone de contact.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- la figure 1 représente, de manière schématique, un schéma de bande d'un photodétecteur,
- les figures 2 à 5 représentent, de manière schématique, une zone barrière pour les électrons.
- les figures 6 à 10 représentent, de manière schématique, différents dopages réalisables pour une barrière d'électrons illustrée à la figure 1.

### Description détaillée

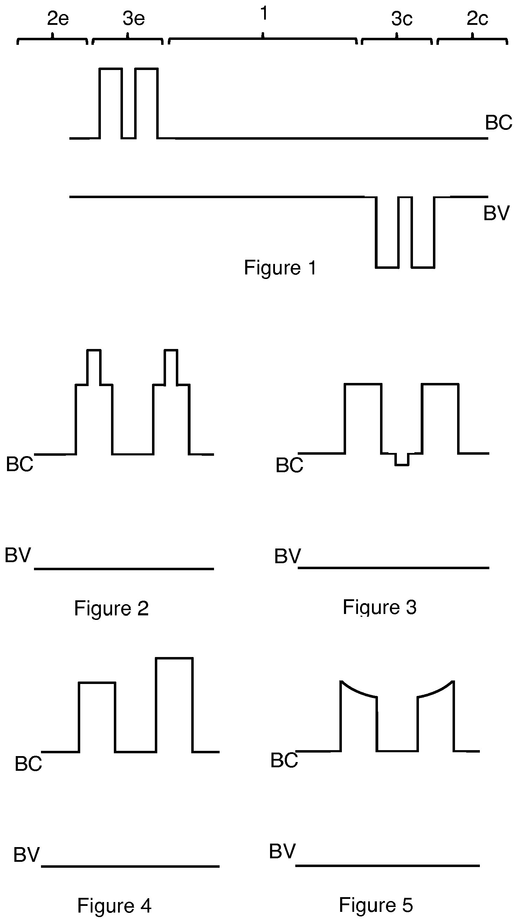

La figure 1 illustre un schéma de bande d'un premier mode de réalisation d'un photodétecteur. Le photodétecteur comporte une zone absorbante 1 en premier matériau semi-conducteur présentant une première valeur d'énergie de bande interdite. La zone absorbante 1 est configurée pour absorber un rayonnement lumineux dans une première gamme de longueur d'onde. De préférence, la zone absorbante 1 est configurée pour absorber et donc détecter un rayonnement dans le domaine de l'infrarouge. Selon les configurations, toutes les bandes du spectre infrarouge peuvent être détectées, mais le dispositif est particulièrement efficace dans le domaine 0,8µm - 30µm et plus particulièrement dans le domaine 3µm - 5µm.

La zone absorbante 1 est reliée d'un côté à un contact émetteur 2e et de l'autre côté à un contact collecteur 2c. En d'autres termes, les contacts émetteur 2e et collecteur 2c sont séparés par la zone absorbante 1. Les zones de contacts 2e, 2c peuvent avantageusement être formées dans un ou plusieurs matériaux semi-conducteurs. De manière préférentielle, les zones de contact 2 sont formées par des matériaux semi-conducteurs dopés de façon à réduire les résistances de contact. Avantageusement, les zones de contact 2 sont recouvertes par un métal. Les zones de contact sont utilisées pour polariser le photodétecteur si nécessaire et collecter les porteurs de charge qui ont été générés.

En fonctionnement, des porteurs de charge électrique sont générés dans la zone absorbante 1 lors de l'absorption du rayonnement lumineux à détecter. Les porteurs de charge électrique sont captés par les zones de contact 2 pour fournir un courant électrique représentatif du rayonnement lumineux détecté.

Entre la zone absorbante 1 et au moins un des contacts 2e, 2c, il est avantageux de disposer une zone de blocage 3 qui s'oppose au passage des porteurs de charge majoritaires entre la zone de contact 2 et la zone absorbante 1. Cette zone de blocage 3 va réduire voire éliminer la composante de courant d'obscurité liée aux défauts électriquement actifs dans la structure et donc va augmenter le rapport signal sur bruit du photodétecteur. En fonctionnement, le photodétecteur génère également des porteurs de charge minoritaires et ces porteurs minoritaires sont mesurés pour déterminer le flux lumineux détecté.

En d'autres termes, si la zone absorbante 1 est majoritairement dopée de type n, il est avantageux d'utiliser une zone de blocage 3 pour les électrons. Il est avantageux de disposer la zone de blocage 3 d'électrons entre la zone absorbante 1 et le contact émetteur 2e. En revanche, si la zone absorbante 1 est majoritairement dopée de type p, il est avantageux d'utiliser une zone de blocage 3 pour les trous d'électrons. Il est avantageux de disposer la zone de blocage 3 de trous entre la zone absorbante 1 et le contact collecteur 2c. De manière préférentielle, la zone absorbante 1 présente une concentration en dopants qui se trouve dans la gamme 1.10¹⁴ - 1.10¹⁷ atomes/cm³.

Dans un mode de réalisation, la zone de blocage 3 est en contact direct avec la zone absorbante 1 pour gagner en compacité. Il est également possible de prévoir que la zone de blocage 3 est en contact direct avec le contact 2e, 2c pour gagner en compacité. Le matériau formant la zone de blocage 3 n'est pas en contact direct avec le matériau métallique qui collecte les charges électriques. Le matériau métallique est séparé de la zone de blocage 3 par le contact 2c ou 2e.

Pour bloquer les porteurs de charge, la zone de blocage 3 comporte au moins un deuxième matériau semi-conducteur qui présente une deuxième valeur de bande interdite supérieure à la première valeur de bande interdite de la zone absorbante 1. De préférence, la largeur de bande interdite de la zone de blocage 3 est au moins deux fois plus grande que la largeur de bande interdite de la zone absorbante 1 c'est-à-dire du premier matériau semi-conducteur. Le deuxième matériau semi-conducteur est également appelé matériau barrière.

Pour bloquer les électrons, le décalage de bande se fait majoritairement dans la bande de conduction. Pour bloquer les trous d'électron, le décalage de bande se fait majoritairement dans la bande de valence.

De manière avantageuse, la différence d'énergie minimale entre les bandes associées aux porteurs majoritaires dans la zone absorbante 1 et dans la zone de blocage est supérieure ou égale à 3kT pour former une zone de blocage performante, où k correspond à la constante de Boltzmann et T correspond à la température en Kelvin du photodétecteur.

Pour une zone de blocage 3 d'électrons, le deuxième matériau semi-conducteur présente un niveau de bande de conduction qui est supérieur au niveau de la bande de conduction du premier matériau semi-conducteur formant la zone absorbante 1. Pour une zone de blocage de trous d'électrons, le deuxième matériau semi-conducteur présente un niveau de bande de valence qui est inférieur au niveau de la bande de valence du premier matériau semi-conducteur formant la zone absorbante 1.

De manière avantageuse, pour éviter de bloquer une partie des porteurs minoritaires, il est avantageux de choisir un matériau barrière qui ne présente pas de décalage de bande avec le matériau de la zone absorbante 1 sur l'autre bande, c'est-à-dire la bande liée aux porteurs minoritaires.

Pour une zone absorbante 1 dopée majoritairement de type n, on recherche un décalage de bande nul ou quasi nul pour la bande de valence. Pour une zone absorbante 1 dopée majoritairement de type p, on recherche un décalage de bande nul ou quasi nul pour la bande de conduction. Il est avantageux de considérer qu'une différence d'énergie inférieure ou égale à 200meV et/ou inférieure ou égale à 3kT est considérée comme un décalage quasi-nul, k correspond à la constant de Boltzmann et T à la température en Kelvin du photodétecteur.

Dans le cas où la zone absorbante 1 est formée par un super-réseau, il est avantageux de considérer que l'énergie de bande interdite de la zone absorbante 1 correspond à la valeur du plus petit écart d'énergie qui existe entre les mini-bandes de trous et les mini-bandes d'électrons.

Dans un mode de réalisation particulièrement avantageux, la zone de blocage 3 est configurée pour former au moins un puits quantique. La zone de blocage 3 comporte au moins le deuxième matériau semi-conducteur et un troisième matériau semi-conducteur. Le troisième matériau semi-conducteur présente une troisième valeur d'énergie de bande interdite qui est différente de la deuxième valeur d'énergie de bande interdite.

Le puits quantique est différent du super-réseau. Dans un super-réseau, il est nécessaire de former plusieurs couches différentes avec une périodicité entre ces différentes couches. Par ailleurs, le super-réseau n'est obtenu qu'au moyen de l'utilisation d'un très grand nombre de répétitions des différentes couches.

De manière avantageuse, la zone de blocage 3 est configurée de manière à ce que les fonctions d'onde de porteurs de charge dans les matériaux puits ne soient pas couplées entre elles. Les fonctions d'onde de porteurs de charge restent localisées dans l'espace réel dans le matériau puits. De manière avantageuse, la zone de blocage 3 est dépourvue de mini-bandes. Cependant, des états quantifiés et localisés peuvent être formés dans le matériau puits. Dans le cas de puits quantiques, les matériaux barrières ont des épaisseurs supérieures aux épaisseurs des matériaux puits, de préférence au moins supérieures à deux fois l'épaisseur du matériau puits, encore plus préférentiellement au moins supérieures à trois fois l'épaisseur du matériau puits.

Au contraire, dans un super-réseau les fonctions d'onde des porteurs des différents matériaux puits sont couplées entre elles. Pour cela les matériaux barrière et puits ont généralement des épaisseurs proches. En résultat, les fonctions d'onde sont délocalisées dans l'espace réel, des mini-bandes apparaissent. Il apparaît qu'une telle architecture avec super-réseau est préjudiciable au bon fonctionnement du détecteur.

De manière avantageuse, la zone de blocage contient moins de 10 zones de puits, c'est-à-dire moins de 10 zones en matériau puits séparées par une zone en matériau barrière. Dans un mode de réalisation avantageux, la zone de blocage contient moins de 7 zones de puits et préférentiellement entre 5 et 7 zones de puits. En alternative, il est possible de prévoir une zone de blocage qui contient moins de 5 zones de puits.

Dans un mode de réalisation avantageux, la zone de blocage est apériodique c'est-à-dire qu'elle est dépourvue de périodicité dans la répétition d'un couple formé par un matériau barrière et un matériau puits. Lorsque la zone de blocage possède plusieurs zones de puits, le défaut de périodicité peut être obtenu en utilisant des épaisseurs différentes entre les différentes zones de puits, l'épaisseur de matériau barrière étant constante entre deux zones de puits consécutives. En alternative, lorsque la zone de blocage possède plusieurs zones de puits, le défaut de périodicité peut être obtenu en utilisant des épaisseurs différentes entre les différentes zones de barrière, l'épaisseur de matériau puits étant constante entre deux zones de barrière consécutives. Il est encore possible de combiner ces enseignements pour faire varier l'épaisseur de la zone de puits et l'épaisseur de la zone barrière.

Dans un autre mode de réalisation qui peut être combiné avec les modes de réalisation précédents, il est possible de modifier le matériau formant la zone barrière et/ou la zone puits entre deux zones barrières successives et deux zones de puits successives.

De manière avantageuse, pour bloquer efficacement les porteurs de charge, les extrémités de la zone de blocage 3 sont formées par le deuxième matériau semi-conducteur et éventuellement un quatrième matériau semi-conducteur qui présente une valeur de bande interdite supérieure à la première valeur de bande interdite de la zone absorbante 1. Comme précédemment, le matériau formant le sommet de la zone de blocage 3 présente une énergie de bande interdite qui est au moins égale à deux fois l'énergie de bande interdite du matériau formant la zone absorbante 1. Le matériau semi-conducteur formant la zone de puits de potentiel peut être identique au premier matériau semi-conducteur formant la zone absorbante 1.

Les extrémités de la zone de blocage 3 d'électrons sont chacune formées par un matériau ayant un niveau de bande de conduction supérieur à celui de la zone absorbante 1 (de type n).

Pour réaliser la zone de blocage 3 de trous, ce qui a été expliqué pour la barrière d'électrons est encore vrai en valeur absolue. Pour la zone de blocage de trous, le quatrième matériau semi-conducteur présente un niveau d'énergie de bande de valence qui est inférieur à celui du premier matériau semi-conducteur de la zone absorbante 1. Le quatrième matériau semi-conducteur présente avantageusement un niveau de bande de valence qui est inférieur au niveau de la bande de valence du troisième matériau semi-conducteur. Là encore, une différence d'énergie minimale supérieure ou égale à 3kT entre les bandes de valence est particulièrement avantageuse pour former une barrière performante. Ce qui a été expliqué précédent pour la différence d'énergie par rapport au contact peut également être appliqué dans ce cas.

Les extrémités de la zone de blocage 3 de trous sont chacune formées par un matériau ayant un niveau de bande de valence inférieur à celui de la zone absorbante 1 et inférieur au niveau de la bande de valence du troisième matériau semi-conducteur. Les extrémités de la zone de blocage 3 peuvent être formées par le deuxième matériau semi-conducteur ou par le quatrième matériau semi-conducteur. Le troisième matériau semi-conducteur peut être identique au premier matériau semi-conducteur formant la zone absorbante 1.

En variante, il est possible de prévoir que la zone de puits soit formée ou partiellement formée par un matériau semi-conducteur qui présente une largeur de bande interdite inférieure à la largeur de bande interdite de la zone absorbante 1. Il est possible de prévoir que la zone de puits soit formée ou partiellement formée par un matériau semi-conducteur qui présente une largeur de bande interdite supérieure à la largeur de bande interdite de la zone absorbante 1.

L'utilisation d'une zone de blocage 3 à base de puits quantiques permet de réduire voire d'éliminer les barrières parasites du photodétecteur ce qui permet de réduire la tension appliquée pour faire fonctionner le photodétecteur et donc d'augmenter la qualité de l'image formée.

Selon les modes de réalisation, le troisième matériau semi-conducteur présente une troisième valeur d'énergie de bande interdite qui est inférieure ou supérieure à la deuxième valeur d'énergie de bande interdite de manière à former au moins un puits quantique. Un puits quantique est une zone de l'espace dans laquelle le potentiel ressenti par une particule quantique atteint un minimum. Le puits quantique représente un puits de potentiel dont les dimensions entrainent une différence entre les prédictions de la mécanique quantique et celles de la mécanique classique.

Les zones de blocage 3 utilisent préférentiellement des matériaux avec des énergies de bande interdite différentes pour former des discontinuités dans la bande de conduction et/ou dans la bande de valence.

La zone de blocage 3 est formée par au moins un matériau de puits qui définit le puits de potentiel et au moins un matériau de barrière qui définit la barrière de potentiel. Selon les modes de réalisation, le deuxième matériau semi-conducteur est un matériau de puits ou de barrière.

Si plusieurs puits quantiques sont formés, il y a de préférence une alternance entre les matériaux formant les zones de puits et les matériaux formant les barrières ou sommets de la zone de blocage 3. Cette configuration permet de former facilement un ou plusieurs puits quantiques dans la zone de blocage 3.

Pour former un puits quantique, l'épaisseur du puits de potentiel est proche de la valeur de la longueur d'onde de la particule. Pour former un puits quantique, il est avantageux de prévoir que l'épaisseur du puits de potentiel, par exemple l'épaisseur du troisième matériau semi-conducteur, est de l'ordre de quelques dizaines de nanomètres, de préférence entre 3Å et 200Å et encore plus préférentiellement entre 3 et 10 nanomètres.

De même, pour former une zone de blocage très efficace, il est également avantageux de prévoir que l'épaisseur du ou des matériaux formant la zone de blocage 3, c'est-à-dire l'épaisseur totale de la zone de blocage 3 est comprise entre 50Å et 5000Å.

Dans un mode de réalisation particulier, le troisième matériau semi-conducteur est entouré par des matériaux ayant une valeur d'énergie de bande interdite plus élevée. Le troisième matériau semi-conducteur définit une zone de puits de potentiel et peut également être appelé matériau de puits.

Les zones de puits sont formées par des matériaux qui ont des largeurs de bande interdite inférieures à la largeur de bande interdite des barrières. Selon les modes de réalisation, la largeur de bande interdite du puits quantique peut être inférieure, identique ou supérieure à la largeur de bande interdite de la zone absorbante 1.

Il est particulièrement avantageux de prévoir que les puits quantiques ne sont définis que dans une seule dimension à savoir selon l'axe de croissance des différentes couches du dispositif, c'est-à-dire l'axe reliant l'émetteur au collecteur.

Dans un mode de réalisation préférentiel, le niveau de l'état quantifié dans le puits quantique est décalé du niveau de la bande d'énergie associée aux porteurs majoritaires, c'est-à-dire du niveau de la bande de conduction du contact (pour une zone absorbante de type n) et/ou du niveau de la bande de valence du contact (pour une zone absorbante de type p). Cette précaution permet de réduire fortement voire d'éliminer les phénomènes de passage des porteurs de charge par effet tunnel.

Pour quasiment éliminer le transport par effet tunnel, il est avantageux d'avoir un décalage en énergie d'une valeur supérieure ou égale à 1*kT où k correspond à la constant de Boltzmann et T à la température en Kelvin du photodétecteur.

Dans un mode de réalisation privilégié, le photodétecteur est formé dans un substrat qui comprend la zone absorbante 1, la zone de blocage 3, la zone de contact 2 et une zone de support. La zone de support est séparée de la zone de contact 2 par la zone absorbante 1 et la zone de blocage 3. La zone de support peut être un substrat initial sur lequel sont déposées les différentes couches du photodétecteur. Selon les modes de réalisation, la couche de support intervient électriquement ou non.

Dans un mode de réalisation préférentiel, deux zones de blocage 3 sont utilisées. Les deux zones de blocage 3 sont séparées par la zone absorbante 1. La zone de blocage 3 est associée à une zone de blocage additionnelle qui est configurée pour bloquer les porteurs minoritaires entre la zone absorbante 1 et la zone de contact additionnelle. La zone de blocage additionnelle est disposée entre la zone absorbante 1 et la zone de contact additionnelle.

Il y a alors une première zone de blocage disposée entre la zone absorbante 1 et un circuit de lecture et une deuxième zone de blocage disposée entre la zone absorbante 1 et la couche de support. La couche de support assure la tenue mécanique des couches du photodétecteur.

L'utilisation d'une zone de blocage 3 disposée du côté de la couche de support permet de réduire et préférentiellement d'éviter les courants parasites qui sont liés à la recombinaison des porteurs de charge à l'interface substrat / zone épitaxiée. A titre d'exemple, le contact collecteur 2c peut être le substrat ou une couche intermédiaire entre le substrat et la zone de blocage 3. Le substrat ou une partie du substrat sert de couche de support. La zone épitaxiée correspond à la zone formée par une ou plusieurs couches déposées par épitaxie sur le substrat. Les couches formées sur le substrat sont par exemple la zone de blocage additionnelle, la zone absorbante, la zone de blocage, la zone de contact, et éventuellement la zone de contact additionnelle.

La zone de blocage additionnelle est avantageusement formée par des cinquième et sixième matériaux semi-conducteurs qui sont configurés pour définir un ou plusieurs puits quantiques. La zone de blocage additionnelle comporte au moins un puits quantique réalisée en cinquième et sixième matériaux semi-conducteurs présentant respectivement des cinquième et sixième valeurs d'énergie de bande interdite. La cinquième et/ou la sixième valeur d'énergie de bande interdite est supérieure à la première valeur d'énergie de bande interdite.

La zone absorbante 1 est alors séparée des contacts émetteur 2e et collecteur 2c par des zones de blocage 3 qui sont toutes les deux configurées pour s'opposer au passage des porteurs de charges. Il y a alors deux zones de blocage 3 séparées par la zone absorbante 1. L'une des zones de blocage s'oppose au passage des électrons alors que l'autre zone de blocage s'oppose au passage des trous.

Que la zone absorbante 1 soit dopée de type n ou de type p, il est avantageux de prévoir que la zone de blocage 3 disposée à proximité du contact avec le circuit de lecture soit configurée pour bloquer les porteurs majoritaires. La zone de blocage 3 disposée du côté de la couche de support est configurée préférentiellement pour bloquer les porteurs minoritaires. Placer la zone de blocage 3 des porteurs majoritaires du côté du contact avec le circuit de lecture permet un fonctionnement plus simple du photodétecteur.

Si le photodétecteur comporte deux zones de blocage disposées respectivement côté émetteur et côté collecteur, il est particulièrement avantageux de prévoir l'utilisation de matériaux barrières différents. La zone de blocage additionnelle est par exemple formée avec un matériau barrière additionnel. Il peut en être de même pour le matériau de puits qui est alors un matériau de puits additionnel. Cependant, il est également possible de prévoir que le matériau de puits additionnel est identique au matériau de puits de la zone de blocage, par exemple le troisième matériau semi-conducteur.

Dans un mode de réalisation avantageux, ce qui a été expliqué pour la zone de blocage peut également être appliqué pour la zone de blocage additionnelle en relation avec les autres porteurs de charge.

Si la zone absorbante est de type n, pour une zone de blocage des électrons, il est avantageux de prévoir que le niveau de bande de valence soit identique ou quasiment identique entre la zone absorbante 1, la zone de blocage 3 d'électrons et le contact 2e. Pour une zone de blocage des trous, il est avantageux de prévoir le niveau de bande de conduction est identique ou quasiment identique entre la zone absorbante 1, la zone de blocage de trous et le contact 2c. En fonction du type de dopage de la zone absorbante 1, la zone de blocage de blocage des trous agit comme zone de blocage des porteurs majoritaires ou minoritaires. Il en va de même pour la zone de blocage d'électrons.

Différents modes de réalisation sont illustrés aux figures 2 à 5. Selon les modes de réalisation, les potentiels évoluent de manière symétrique ou non par rapport à un plan qui se situe au centre de la zone de blocage 3 (selon l'épaisseur). La zone de blocage 3 comporte alors des matériaux différents pour former les différentes zones barrières ou les mêmes matériaux pour former des barrières avec des compositions variables.

Dans un mode de réalisation, une des barrières ou plusieurs barrières peuvent présenter un gradient de composition. Dans un mode de réalisation encore plus particulier, le gradient de composition définit un profil parabolique sur la bande de conduction ou sur la bande de valence de la barrière. De manière avantageuse, un profil parabolique peut être obtenu au moyen d'un alliage de type AlₓGa₁₋ₓSb dont la composition varie entre Al_{0,1}Ga_{0,9}Sb et Al_{0,42}Ga_{0,58}Sb pour former par exemple un profil tel que représenté à la figure 5.

Dans un mode de réalisation particulièrement avantageux, une zone de barrière est réalisée par plusieurs matériaux semi-conducteurs différents de sorte que la zone de sommet présente une évolution de son niveau de bande de conduction sur son épaisseur, dans le cas d'une barrière d'électrons. Dans le cas d'une barrière de trous, plusieurs matériaux peuvent être utilisés de manière à ce que le sommet présente une évolution du niveau de la bande de valence.

Dans le mode de réalisation illustré à la figure 2, les deux zones de barrière sont formées par au moins deux matériaux ayant des énergies de bande interdite différentes de sorte que le matériau ayant la plus grande énergie de bande interdite soit entouré par un autre matériau de sommet ayant une énergie de bande interdite plus petite. Dans un mode de réalisation, le matériau de sommet ayant la bande interdite la plus grande est placé au centre de la zone de sommet de manière à respecter une symétrie dans les potentiels. En variante, la position du sommet de la zone de barrière peut être quelconque. Il est également possible de prévoir que le matériau ayant la plus grande énergie de bande interdite ne soit pas entouré de chaque côté par un autre matériau de sommet ayant une largeur de bande interdite plus faible.

Dans le mode de réalisation de la figure 3, le matériau définissant le puits de potentiel présente une largeur de bande interdite inférieure à celle du matériau de la zone absorbante 1. En variante non représentée, le matériau définissant le puits de potentiel présente une largeur de bande interdite supérieure à celle du matériau de la zone absorbante 1.

Dans le mode de réalisation de la figure 4, les deux zones de sommet qui entourent le puits quantique sont formées par deux matériaux différents et qui présentent des valeurs différentes de largeur de bande interdite. La zone de blocage 3 ne présente pas une évolution symétrique des potentiels par rapport au centre de la zone de blocage 3.

Dans le mode de réalisation de la figure 5, les deux zones de sommet qui entourent le puits quantique sont formées par plusieurs matériaux de manière à ce que la valeur de l'énergie de bande de conduction évolue graduellement au fur et à mesure que l'on s'éloigne de la zone de puits de potentiel. Il est possible d'utiliser des alliages pour lesquels la composition et/ou le dopage évoluent spatialement.

Les différents modes de réalisation présentés ci-dessus peuvent être combinés entre eux. Par exemple, il est possible de réaliser une zone sommet selon le mode de réalisation de la figure 2 et une autre zone sommet selon le mode de réalisation de la figure 5. Il est aussi possible d'utiliser plus de deux matériaux barrières pour former une barrière et/ou plus de deux matériaux puits pour former un puits quantique.

Les différents modes de réalisation illustrent des zones de blocage d'électrons avec modulation du niveau de la bande de conduction. Il est bien entendu possible de réaliser les mêmes structures en modulant le niveau de la bande de valence pour former des zones de blocage de trous d'électrons.

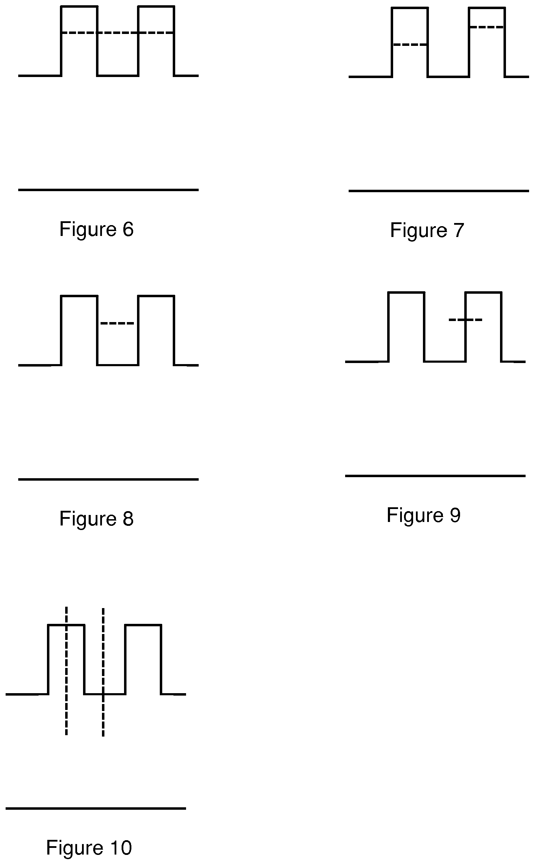

Afin de rendre la zone de blocage 3 plus efficace, il est particulièrement avantageux de doper la zone de blocage pour bloquer des électrons et/ou des trous. La zone de blocage 3 peut être dopée sur toute son épaisseur ou seulement sur une partie de son épaisseur. La figure 6 illustre un dopage de la zone de blocage 3 sur toute son épaisseur. La concentration en dopants ainsi que la répartition des dopants dans les différentes couches de la zone de blocage 3 sont représentées de manière très schématique. La figure 6 mélange ainsi une représentation en énergie des bandes de valence et de conduction et une représentation de la distribution spatiale des dopants sur l'épaisseur du photodétecteur. Les figures 6 à 9 ne représentent pas les niveaux de Fermi, ni les niveaux de confinement énergétique dans les matériaux des puits quantiques.

Doper la zone de blocage 3 permet de transférer des porteurs de charge à l'interface entre la zone de blocage 3 et la zone absorbante 1 ce qui permet de réduire la zone de déplétion. Doper la zone de blocage 3 permet de réduire le volume de la zone de charge d'espace dans la zone absorbante 1 et préférentiellement de ne pas avoir de zone de charge d'espace dans la zone absorbante 1.

L'utilisation d'une zone de blocage 3 dopée avec au moins un puits quantique permet un meilleur contrôle du niveau de dopage effectif et un meilleur contrôle de la distribution des porteurs de charge au point de fonctionnement du photodétecteur. Plus particulièrement, une telle structure permet de gérer plus facilement les contraintes inhérentes aux techniques de croissance cristalline, par exemple la croissance par épitaxie par jets moléculaires ou la croissance par épitaxie en phase vapeur aux organométalliques, pour lesquelles il peut exister une influence du niveau résiduel d'impuretés sur le dopage effectif des matériaux formant la zone de blocage 3.

Cette configuration permet de mieux maitriser la densité de porteurs de charge en modulant l'épaisseur et la position de la zone dopée au sein de la zone de blocage 3. Le photodétecteur est moins sensible que les dispositifs de l'art antérieur vis-à-vis des conditions de croissance et des incertitudes de réalisation induites par les aléas des conditions réelles de croissance.

Dans un cas particulier, un des sommets de la zone de blocage 3 est dopé sur toute son épaisseur. En variante, plusieurs sommets sont dopés sur toute leur épaisseur. Dans un dernier cas de figure illustré à la figure 7, chaque sommet est dopé sur toute son épaisseur. Dans le mode de réalisation particulier illustré, deux niveaux de dopage différents sont représentés sur les deux sommets de la zone de blocage 3. Des dopages identiques sont également possibles.

Il est également possible de prévoir qu'un puits soit dopé sur toute son épaisseur ou que plusieurs puits soient dopés sur toute leur épaisseur. En alternative, il est possible de réaliser un photodétecteur où uniquement tous les matériaux puits sont dopés sur toute leur épaisseur. La figure 8 illustre le dopage du puits de la zone de blocage 3.

En variante à ce qui a été indiqué précédemment, il est possible de remplacer le dopage complet de l'épaisseur d'un puits ou d'un sommet par un dopage sur seulement une partie de l'épaisseur du puits ou du sommet.

Il est également possible de prévoir que la zone dopée recouvre une partie du puits et une partie d'un sommet comme illustré à la figure 9.

Dans un mode de réalisation pouvant être combiné avec ce qui a été décrit précédemment, le dopage est réalisé sur une zone de faible épaisseur, par exemple sur une épaisseur inférieure à 10nm. Dans un cas particulier, le dopage est réalisé sur un ou plusieurs plans atomiques, par exemple moins de 5 plans atomiques pour obtenir une structure dite de Delta Doping ou δ-Doping. Le mode de réalisation illustré à la figure 10 représente l'utilisation de deux plans de dopage. Un premier plan de dopage est réalisé dans la barrière alors que le deuxième plan de dopage est réalisé dans le puits de potentiel. Là encore, ce mode de réalisation peut être combiné avec ce qui a été décrit précédemment.

Par exemple, le dopage est effectué à une des extrémités de la zone de blocage soit dans le matériau de barrière en contact avec le contact émetteur ou collecteur soit dans le matériau de barrière en contact avec la zone absorbante 1.

Dans une variante de réalisation, plusieurs zones dopées différentes peuvent être réalisées dans une zone de puits et/ou dans une zone de sommet. Bien entendu, il est possible de réaliser différentes zones dopées avec des niveaux de dopages différents. Il est encore possible de combiner les différents modes de réalisation indiqués ci-dessus.

Les différents modes de réalisation indiqués ci-dessus peuvent bien entendu être combinés, un dopage de toute l'épaisseur de la zone de blocage, n'est pas incompatible avec l'utilisation d'un plan de dopage. Différents niveaux de dopage sont également utilisables. Les modes de réalisation illustrés aux figures 6 et 9 représentent une zone de blocage 3 illustrée à la figure 1. Il est bien entendu possible de combiner les différents modes de dopages indiqués avec l'une quelconque des zones de blocage indiquées précédemment et/ou illustrées aux figures 1 à 5. Il peut en être de même pour une zone de blocage des trous.

De manière préférentielle, le nombre de puits dans la zone de blocage 3 est inférieur ou égal à 10 de manière à avoir un effet notable sur les courants parasites sans entrainer une forte complexification de la structure du photodétecteur.

Si plusieurs zones dopées sont réalisées dans une zone de blocage 3, il est possible de faire varier les niveaux de dopages entre les zones dopées. Si toute la zone de blocage 3 est dopée, il est possible d'avoir un niveau de dopage constant sur toute la zone de blocage 3 ou alors des variations sur l'épaisseur de la zone de blocage 3.

Dans un mode de réalisation, les zones de blocage 3 sont formées par des empilements de matériaux qui présentent des paramètres de mailles différents. Dans ce cas de figure, il est particulièrement avantageux de choisir les différents matériaux formant la zone de blocage 3 pour qu'il existe au moins une compensation partielle des contraintes entre les couches formant la zone de blocage 3 par rapport au substrat semi-conducteur supportant la zone de absorbante et/ou la couche de support.

Dans un mode de réalisation, les couches semi-conductrices formant les puits de potentiel sont contraintes en tension ou en compression et les couches semi-conductrices formant les sommets sont respectivement contraintes en compression ou en tension pour compenser au moins partiellement les contraintes des puits. Il est alors possible de réaliser des zones de blocage 3 ayant des épaisseurs importantes sans risquer une dégradation de la qualité cristallographique à cause des phénomènes de relaxation des contraintes.

Dans un mode de réalisation simplifié, le deuxième matériau semi-conducteur est contraint en tension et le troisième matériau semi-conducteur est contraint en compression. En variante, le deuxième matériau semi-conducteur est contraint en compression et le troisième matériau semi-conducteur est contraint en tension.

Dans un mode de réalisation particulier, la zone absorbante 1 est réalisée en matériau de type III-V ou II-VI par exemple en Hg₁₋ₓCdₓTe et avantageusement dans un alliage de InAsSb pour détecter un rayonnement ayant une longueur d'onde comprise entre 1 µm et 5,8µm. En variante, le matériau de la zone absorbante 1 peut être choisi parmi InAs, InGaAs, des supers réseaux de InAs/In₁₋ₓGaₓSb ou InAs/In₁₋ₓAsₓSb. Comme indiqué plus haut, le matériau de la zone absorbante 1 peut être dopé majoritairement de type n ou de type p. La zone absorbante 1 peut également être non intentionnellement dopée. De manière plus particulière, le matériau de la zone absorbante 1 peut être choisi parmi Ga_{g}In_{b}Al_{1-a-b}As_{1-c}Sb_{c}, les supers réseaux de Ga_{g}In_{b}Al_{1-a-b}As_{1-c}Sb_{c}/ Ga_{d}InₑAl_{1-d-e}As_{1-f}Sb_{f}, avec 0≤a≤1, 0≤b≤1, 0≤c≤1, 0≤d≤1, 0≤e≤1 et 0≤f≤1.

La zone de blocage 3 peut être formée avec des matériaux choisis parmi AlSb, AlGaSb, AlAsSb, GaAlAsSb, AlPSb, AlGaPSb pour le deuxième matériau semi-conducteur et plus généralement pour les matériaux de barrière. Pour le troisième matériau semi-conducteur et plus généralement pour les matériaux de puits, il est possible de reprendre les matériaux cités pour le deuxième matériau semi-conducteur ainsi que les matériaux cités pour former le premier matériau semi-conducteur. De manière plus particulière, le troisième matériau semi-conducteur peut être choisi parmi Ga_{g}In_{b}Al_{1-a-b}As_{1-c}Sb_{c}, les supers réseaux de GaₐIn_{b}Al_{1-a-b}As_{1-c}Sb_{c}/ Ga_{d}InₑAl_{1-d-e1-f}Sb_{f}, avec 0≤a≤1, 0≤b≤1, 0≤c≤1, 0≤d≤1, 0≤e≤1 et 0≤f≤1.

Les matériaux formant les contacts 2 peuvent être choisis parmi InAs, InAsSb, InGaAs, les supers réseaux de InAs/In₁₋ₓAlₓSb ou InAs/InGaSb et GaSb. Les matériaux des zones de contact peuvent être dopés majoritairement de type n ou de type p. De manière plus particulière, le matériau des contacts peut être choisi parmi Ga_{g}In_{b}Al_{1-a-b}As_{1-c}Sb_{c}, les supers réseaux de Ga_{g}In_{b}Al_{1-a-b}Sb_{c}/ Ga_{d}InₑAl_{1-d-e}Sb_{f}, avec 0≤a≤1, 0≤b≤1, 0≤c≤1, 0≤d≤1, 0≤e≤1 et 0≤f≤1.

Alors que dans les dispositifs de l'art antérieur, la zone de blocage est réalisée par un seul matériau, l'utilisation d'une zone de blocage 3 avec des puits quantiques permet de réduire les courants parasites ce qui permet de réduire la polarisation appliquée pour faire fonctionner le photodétecteur ce qui est bénéfique pour sa fonctionnalité et en particulier son opérabilité. Un tel photodétecteur permet donc une diminution de la consommation électrique.

Dans le cas où plusieurs photodétecteurs sont intégrés dans une matrice de détection, il est possible de réduire la consommation électrique de la matrice de détection en augmentant la température de fonctionnement, mais il est surtout possible de réduire le nombre de pixels atypiques ce qui permet l'obtention d'une image de meilleure qualité.

En d'autres termes, un tel photodétecteur permet un fonctionnement à une température supérieure pour une qualité d'image équivalente (pour un même niveau de bruit). Le photodétecteur et la matrice de détection présentent une meilleure opérabilité et ils peuvent fonctionner sur une plage de température plus importante.

En réduisant les courants parasites, il est possible d'augmenter la température de fonctionnement du plan focal contenant les photodétecteurs. Cette augmentation de la température de fonctionnement permet de réduire la consommation du système de refroidissement et/ou de réduire la taille du système de refroidissement et/ou d'augmenter la fiabilité du dispositif de détection.

## Revendications

1. Photodétecteur, comportant:
- une zone absorbante (1) formée par un premier matériau semi-conducteur ayant une première valeur d'énergie de bande interdite,
- une zone de contact (2e, 2c) réalisée en matériau semi-conducteur,
- une zone de blocage (3e, 3c) formée par au moins un deuxième matériau semi-conducteur configuré pour s'opposer au passage des porteurs de charge majoritaires entre la zone absorbante (1) et la zone de contact (2e, 2c), le deuxième matériau semi-conducteur présentant une deuxième valeur d'énergie de bande interdite supérieure à la première valeur d'énergie de bande interdite,
photodétecteur **caractérisé en ce que** la zone de blocage (3e, 3c) est dopée et configurée pour former au moins un puits quantique au moyen du deuxième matériau semi-conducteur et d'un troisième matériau semi-conducteur ayant une troisième valeur d'énergie de bande interdite différente de la deuxième valeur d'énergie de bande interdite, le deuxième matériau semi-conducteur et le troisième matériau semi-conducteur définissant un matériau barrière et un matériau puits, le matériau barrière ayant une valeur d'énergie de bande interdite supérieure à la valeur d'énergie de bande interdite du matériau puits, l'épaisseur du matériau barrière étant supérieure à l'épaisseur du matériau puits, **en ce que** la zone de blocage (3e, 3c) est configurée de manière à ce que les fonctions d'onde de porteurs de charge dans le matériau puits ne soient pas couplées entre elles, les fonctions d'onde de porteurs de charge étant localisées dans l'espace réel dans le matériau puits, et **en ce que** la zone de blocage (3e, 3c) est dépourvue de mini-bandes.

2. Photodétecteur selon la revendication 1, dans lequel l'épaisseur du deuxième matériau semi-conducteur est au moins deux fois supérieure à l'épaisseur du troisième matériau semi-conducteur, le deuxième matériau formant un matériau barrière et le troisième matériau formant un matériau puits.

3. Photodétecteur selon l'une quelconque des revendications précédentes, dans lequel la zone de blocage (3e, 3c) comporte un quatrième matériau semi-conducteur présentant une quatrième valeur d'énergie de bande interdite supérieure à la première valeur d'énergie de bande interdite et différente de la deuxième valeur d'énergie de bande interdite et de la troisième valeur d'énergie de bande interdite.

4. Photodétecteur selon l'une quelconque des revendications précédentes, **caractérisé en ce qu'**il comporte un substrat comprenant la zone absorbante (1), la zone de blocage (3e, 3c), la zone de contact (2e, 2c) et une zone de support et **en ce que** la zone de support est séparée de la zone de contact (2e, 2c) par la zone absorbante (1) et la zone de blocage (3e, 3c).

5. Photodétecteur selon la revendication 4, **caractérisé en ce qu'**il comporte :
- une zone de contact additionnelle (2c, 2e) et
- une zone de blocage additionnelle (3e, 3c) disposée entre la zone absorbante (1) et la zone de contact additionnelle (2c, 2e), la zone de blocage additionnelle (3e, 3c) étant configurée pour bloquer les porteurs de charge minoritaires entre la zone absorbante (1) et la zone de contact additionnelle (2c, 2e).

6. Photodétecteur selon la revendication 5, **caractérisé en ce que** la zone de contact additionnelle (2c, 2e) est disposée entre la zone de support et la zone absorbante (1).

7. Photodétecteur selon l'une des revendications 5 et 6, **caractérisé en ce que** la zone de blocage additionnelle (3e, 3c) comporte au moins un puits quantique réalisé en cinquième et sixième matériaux semi-conducteurs présentant respectivement des cinquième et sixième valeurs d'énergie de bande interdite, la cinquième et/ou la sixième valeur d'énergie de bande interdite étant supérieure à la première valeur d'énergie de bande interdite.

8. Photodétecteur selon l'une des revendications précédentes, **caractérisé en ce que** le premier matériau semi-conducteur est le troisième matériau semi-conducteur et/ou le cinquième matériau semi-conducteur.

9. Photodétecteur selon l'une des revendications précédentes, **caractérisé en ce que** la zone de blocage (3e, 3c) et/ou la zone de blocage additionnelle sont dopées sur toute leur épaisseur.

10. Photodétecteur selon l'une quelconque des revendications précédentes, **caractérisé en ce que** la zone de blocage (3e, 3c) définit une ou plusieurs zones de puits de potentiel et plusieurs zones de barrière de potentiel et **en ce que** la zone de blocage (3e, 3c) est dopée uniquement dans une ou plusieurs desdites zones de puits de potentiel.

11. Photodétecteur selon l'une quelconque des revendications 1 à 9, **caractérisé en ce que** la zone de blocage (3e, 3c) définit une ou plusieurs zones de puits de potentiel et plusieurs zones de barrière de potentiel et **en ce que** la zone de blocage (3e, 3c) est dopée uniquement hors de la ou des zones de puits de potentiel.

12. Photodétecteur selon l'une quelconque des revendications précédentes, **caractérisé en ce que** la zone de blocage (3e, 3c) comporte une alternance de couches en deuxième matériau semi-conducteur et en troisième matériau semi-conducteur et **en ce que** les couches en deuxième matériau semi-conducteur sont contraintes en tension et les couches en troisième matériau semi-conducteur sont contraintes en compression.

13. Photodétecteur selon l'une quelconque des revendications précédentes, **caractérisé en ce que** la zone de blocage (3e, 3c) comporte entre 1 et 10 puits quantiques.

14. Photodétecteur selon l'une quelconque des revendications précédentes, **caractérisé en ce que** la zone de blocage (3e, 3c) est en contact direct avec la zone absorbante (1).

15. Photodétecteur selon l'une quelconque des revendications précédentes, **caractérisé en ce que** la zone de blocage (3e, 3c) est en contact direct avec la zone de contact (2e, 2c).

## Patentansprüche

1. Fotodetektor, umfassend:
- eine absorbierende Zone (1), die von einem ersten Halbleitermaterial mit einem ersten Energiebandlückenwert gebildet ist,
- eine Kontaktzone (2e, 2c), die aus einem Halbleitermaterial hergestellt ist,
- eine Blockierungszone (3e, 3c), die aus mindestens einem zweiten Halbleitermaterial gebildet ist, das eingerichtet ist, um sich dem Durchgang der Majoritätsladungsträger zwischen der absorbierenden Zone (1) und der Kontaktzone (2e, 2c) zu widersetzen, wobei das zweite Halbleitermaterial eine zweiten Energiebandlückenwert aufweist, der größer als der erste Energiebandlückenwert ist,
wobei der Fotodetektor **dadurch gekennzeichnet ist, dass** die Blockierungszone (3e, 3c) dotiert und eingerichtet ist, um mindestens einen Quantentopf mit Hilfe des zweiten Halbleitermaterials und eines dritten Halbleitermaterials mit einem dritten Energiebandlückenwert, der sich vom zweiten Energiebandlückenwert unterscheidet, zu bilden, wobei das zweite Halbleitermaterial und das dritte Halbleitermaterial ein Barrierematerial und ein Topfmaterial definieren, wobei das Barrierematerial einen Energiebandlückenwert hat, der größer als der Energiebandlückenwert des Topfmaterials ist, wobei die Dicke des Barrierematerials größer als die Dicke des Topfmaterials ist, dass die Blockierungszone (3e, 3c) derart eingerichtet ist, dass die Ladungsträgerwellenfunktionen in dem Topfmaterial nicht miteinander gekoppelt werden, wobei die Ladungsträgerwellenfunktionen im realen Raum im Topfmaterial lokalisiert sind, und dass die Blockierungszone (3e, 3c) keine Minibänder aufweist.

2. Fotodetektor nach Anspruch 1, bei dem die Dicke des zweiten Halbleitermaterials mindestens zweimal größer als die Dicke des dritten Halbleitermaterials ist, wobei das zweite Halbleitermaterial ein Barrierematerial bildet und das dritte Material ein Topfmaterial bildet.

3. Fotodetektor nach einem der vorhergehenden Ansprüche, bei dem die Blockierungszone (3e, 3c) ein viertes Halbleitermaterial umfasst, das einen vierten Energiebandlückenwert aufweist, der größer als der erste Energiebandlückenwert ist, und der sich von dem zweiten Energiebandlückenwert und dem dritten Energiebandlückenwert unterscheidet.

4. Fotodetektor nach einem der vorhergehenden Ansprüche, **dadurch gekennzeichnet, dass** er ein Substrat umfasst, umfassend die absorbierende Zone (1), die Blockierungszone (3e, 3c), die Kontaktzone (2e, 2c) und eine Trägerzone, und dass die Trägerzone von der Kontaktzone (2e, 2c) durch die absorbierende Zone (1) und die Blockierungszone (3e, 3c) getrennt ist.

5. Fotodetektor nach Anspruch 4, **dadurch gekennzeichnet, dass** er umfasst:
- eine zusätzliche Kontaktzone (2c, 2e) und
- eine zusätzliche Blockierungszone (3e, 3c), die zwischen der absorbierenden Zone (1) und der zusätzlichen Kontaktzone (2c, 2e) angeordnet ist, wobei die zusätzliche Blockierungszone (3e, 3c) eingerichtet ist, um die Minoritätsladungsträger zwischen der absorbierenden Zone (1) und der zusätzlichen Kontaktzone (2c, 2e) zu blockieren.

6. Fotodetektor nach Anspruch 5, **dadurch gekennzeichnet, dass** die zusätzliche Kontaktzone (2c, 2e) zwischen der Trägerzone und der absorbierenden Zone (1) angeordnet ist.

7. Fotodetektor nach einem der Ansprüche 5 und 6, **dadurch gekennzeichnet, dass** die zusätzliche Blockierungszone (3e, 3c) mindestens einen Quantentopf umfasst, der aus einem fünften und sechsten Halbleitermaterial hergestellt ist, die fünfte bzw. sechste Energiebandlückenwerte aufweisen, wobei der fünfte und/oder sechste Energiebandlückenwert größer als der erste Energiebandlückenwert ist.

8. Fotodetektor nach einem der vorhergehenden Ansprüche, **dadurch gekennzeichnet, dass** das erste Halbleitermaterial das dritte Halbleitermaterial und/oder das fünfte Halbleitermaterial ist.

9. Fotodetektor nach einem der vorhergehenden Ansprüche, **dadurch gekennzeichnet, dass** die Blockierungszone (3e, 3c) und/der die zusätzliche Blockierungszone auf ihrer gesamten Dicke dotiert sind.

10. Fotodetektor nach einem der vorhergehenden Ansprüche, **dadurch gekennzeichnet, dass** die Blockierungszone (3e, 3c) eine oder mehrere Potentialtopfzonen und mehrere Potentialbarrierezonen definiert, und dass die Blockierungszone (3e, 3c) nur in einer oder mehreren der Potentialtopfzonen dotiert ist.

11. Fotodetektor nach einem der Ansprüche 1 bis 9, **dadurch gekennzeichnet, dass** die Blockierungszone (3e, 3c) eine oder mehrere Potentialtopfzonen und mehrere Potentialbarrierezonen definiert, und dass die Blockierungszone (3e, 3c) nur außerhalb der Potentialtopfzone(n) dotiert ist.

12. Fotodetektor nach einem der vorhergehenden Ansprüche, **dadurch gekennzeichnet, dass** die Blockierungszone (3e, 3c) eine Wechselfolge von Schichten aus zweitem Halbleitermaterial und aus drittem Halbleitermaterial umfasst, und dass die Schichten aus zweitem Halbleitermaterial in Spannung belastet werden und die Schichten aus drittem Halbleitermaterial in Kompression belastet werden.

13. Fotodetektor nach einem der vorhergehenden Ansprüche, **dadurch gekennzeichnet, dass** die Blockierungszone (3e, 3c) zwischen 1 und 10 Quantentöpfe umfasst.

14. Fotodetektor nach einem der vorhergehenden Ansprüche, **dadurch gekennzeichnet, dass** die Blockierungszone (3e, 3c) mit der absorbierenden Zone (1) in direktem Kontakt ist.

15. Fotodetektor nach einem der vorhergehenden Ansprüche, **dadurch gekennzeichnet, dass** die Blockierungszone (3e, 3c) mit der Kontaktzone (2e, 2c) in direktem Kontakt ist.

## Claims

1. Photodetector, comprising:
- a absorbing region (1) formed by a first semiconductor material having a first bandgap energy value,
- a contact region (2e, 2c) made from semiconductor material,
- a blocking region (3e, 3c) formed by at least a second semiconductor material configured to oppose flow of the majority charge carriers between the absorbing region (1) and the contact region (2e, 2c), the second semiconductor material presenting a second bandgap energy value higher than the first bandgap energy value,
photodetector **characterized in that** the blocking region (3e, 3c) is doped and configured to form at least one quantum well by means of the second semiconductor material and a third semiconductor material having a third bandgap energy value different from the second bandgap energy value, the second semiconductor material and the third semiconductor material defining a barrier material and a potential well material, the barrier material having a bandgap energy value higher than a bandgap energy value of the potential well material, the thickness of the barrier material being greater than the thickness of the potential well material, and **in that** the blocking region (3e, 3c) is configured so that the charge carrier wave functions in the well materials are not coupled to one another, the charge carrier wave functions being localised in the real space of the well material and **in that** the blocking region (3) is devoid of mini-bands.

2. Photodetector according to claim 1, wherein the thickness of the second semiconductor material is at least twice that of the thickness of the third semiconductor material the second semiconductor material forming a barrier material and the third semiconductor material forming potential well material.

3. Photodetector according to any one of the foregoing claims, wherein the blocking region (3e, 3c) comprises a fourth semiconductor material presenting a fourth bandgap energy value higher than the first bandgap energy value and different from the second bandgap energy value and from the third bandgap energy value.

4. Photodetector according to any one of the foregoing claims, **characterized in that** it comprises a substrate comprising the absorbing region (1), the blocking region (3e, 3c), the contact region (2e, 2c) and a support region, and **in that** the support region is separated from the contact region (2e, 2c) by the absorbing region (1) and the blocking region (3e, 3c).

5. Photodetector according to claim 4, **characterized in that** it comprises:
- an additional contact region (2c, 2e) and
- an additional blocking region (3e, 3c) arranged between the absorbing region (1) and the additional contact region (2c, 2e), the additional blocking region (3e, 3c) being configured to block the minority charge carriers between the absorbing region (1) and the additional contact region (2c, 2e).

6. Photodetector according to claim 5, **characterized in that** the additional contact region (2c, 2e) is located between the support region and the absorbing region (1).

7. Photodetector according to one of claims 5 and 6, **characterized in that** the additional blocking region (3e, 3c) comprises at least one quantum well made from fifth and sixth semiconductor materials respectively presenting fifth and sixth bandgap energy values, the fifth and/or sixth bandgap energy value being higher than the first bandgap energy value.

8. Photodetector according to one of the foregoing claims, **characterized in that** the first semiconductor material is the third semiconductor material and/or the fifth semiconductor material.

9. Photodetector according to one of the foregoing claims, **characterized in that** the blocking region (3e, 3c) and/or the additional blocking region are doped over their whole thickness.

10. Photodetector according to any one of the foregoing claims, **characterized in that** the blocking region (3e, 3c) defines one or more potential well regions and several potential barrier regions and **in that** the blocking region (3e, 3c) is doped only in one or more of said potential well regions.

11. Photodetector according to any one of claims 1 to 9, **characterized in that** the blocking region (3e, 3c) defines one or more potential well regions and several potential barrier regions and **in that** the blocking region (3e, 3c) is doped only outside the potential well region or regions.

12. Photodetector according to any one of the foregoing claims, **characterized in that** the blocking region (3e, 3c) comprises an alternation of layers of second semiconductor material and of third semiconductor material and **in that** the layers of second semiconductor material are tensile stressed and the layers of third semiconductor material are compressive stressed.

13. Photodetector according to any one of the foregoing claims, **characterized in that** the blocking region (3e, 3c) comprises between 1 and 10 quantum wells.

14. Photodetector according to any one of the foregoing claims, **characterized in that** the blocking region (3e, 3c) is in direct contact with the absorbing region (1).

15. Photodetector according to any one of the foregoing claims, **characterized in that** the blocking region (3e, 3c) is in direct contact with the contact region (2e, 2c).
